# EUROPEAN PATENT SPECIFICATION

(11) **EP 2 822 179 B1**
(45) Date of publication and mention of the grant of the patent: **01.05.2019**
(21) Application number: 14175120.6
(22) Date of filing: 01.07.2014
(51) Int. Cl.: H03K 17/14, H03F 3/72, H05B 37/02, H03K 17/16

(54) **Light projecting device drive circuit and photoelectric sensor**
Lichtprojektionsvorrichtungstreiberschaltung und fotoelektrischer Sensor
Circuit d'entraînement d'un dispositif de projection de lumière et capteur photoélectrique

(30) Priority: 04.07.2013 JP 2013140739
(43) Date of publication of application: 07.01.2015
(73) Proprietor: Azbil Corporation, Chiyoda-ku Tokyo 100-6419 (JP)
(72) Inventor: Kajita, Tetsuya, Tokyo, Tokyo 100-6419 (JP)
(74) Representative: Lavoix

(56) References cited:
- US-A- 4 808 943
- US-A- 5 512 850

## Description

### Background

The present invention relates to a light projecting device drive circuit that outputs a current for driving a light projecting device and to a photoelectric sensor.

US 5 512 850 A describes a slew rate buffer circuit having a switch networks to increase slew rat. The buffer circuit is composed of the high gain, low slew rate amplifier and switches.

US 4 808 943 A discloses a switching circuit of an output from an amplifier of which output gain is controlled by a negative feedback.

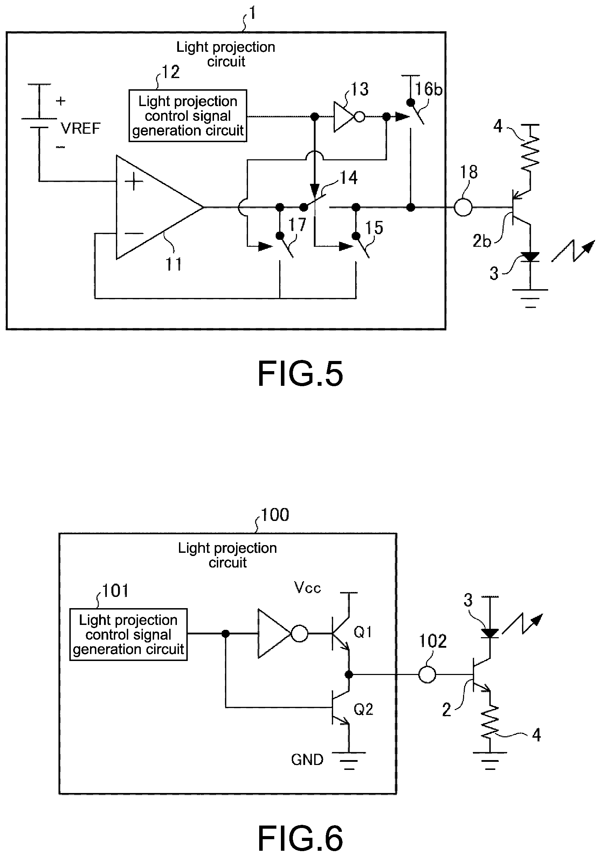

When turning on a light-emitting diode (LED) for an object detection, a photoelectric sensor turns on/off the LED in a pulsed manner for reducing deterioration of the LEDs (e.g., see Japanese Patent Application Laid-open No. HEI 03-289714). Specifically, for example, as in a light projecting LED drive circuit (light projecting device drive circuit) shown in Fig. 6, an LED 3 is turned on/off in a pulsed manner by switching a base voltage of an LED drive transistor 2b between Vcc/GND according to a light projection control signal output from a light projection control signal generation circuit 101 in a light projection circuit 100. Actually, upon turn-on of the LED 3, a voltage obtained by subtracting a collector-emitter voltage (Vce voltage) of a transistor Q1 from a Vcc voltage is applied to the base of the LED drive transistor 2 (output voltage 102). Further, in order to limit an LED current, a LED current-limiting resistor 4 is connected to the emitter of the LED drive transistor 2.

### Summary

By the way, a photoelectric switch is a switch that detects the presence or absence of a detection target object by detecting a signal intensity of a light reception signal. Therefore, for example, when a semi-transparent detection target object is detected, there is a need for determining a minute change in light attenuating due to the detection target object. However, if the light reception signal largely varies, it is difficult to judge whether such a variation is caused by the presence or absence of the detection target object or a fluctuation of the light reception signal itself. In order to reduce such a variation of the light reception signal, it is first necessary to make the LED current constant.

A base-emitter voltage (Vbe voltage) of the LED drive transistor 2 changes depending on the temperature. It is known that the temperature property is about -2 mV/°C. Thus, such a change can be estimated to some extent.

In the conventional circuit shown in Fig. 6, due to the presence of a Vce voltage of the transistor Q1, the voltage applied to the base of the LED drive transistor 2 (output terminal 102) is significantly affected by a fluctuation in temperature. In addition, the Vce voltage largely varies depending on the type of circuit. Thus, the LED current fluctuates due to the fluctuation in temperature.

As described above, although a drive circuit with a transistor is generally known, there is a problem in that the voltage applied to the base of the LED drive transistor 2 is significantly affected by the fluctuation in temperature and hence it is impossible to output a stable LED current.

The present invention has been made for solving such a problem and it is an object thereof to provide a light projecting device drive circuit that is capable of outputting a stable LED current without a voltage applied to a base of an LED drive transistor being affected by fluctuations in external factors such as a temperature, and a photoelectric sensor.

According to the present invention, there is provided a light projecting device drive circuit according to claims 1 and 4.
According to an embodiment a voltage generation circuit generates a voltage. A voltage-to-current converting circuit generates a current. A cut-off switch switches connection/disconnection between an output of the voltage generation circuit and an input of the voltage-to-current converting circuit. A bypass switch switches connection/disconnection between the input of the voltage-to-current converting circuit, which is connected to the cut-off switch, and an input of a feedback voltage of the voltage generation circuit. An off-switch switches connection/disconnection between the input of the voltage-to-current converting circuit, which is connected to the cut-off switch, and a potential different from a potential at the output of the voltage generation circuit. A stabilization switch switches connection/disconnection between the output of the voltage generation circuit, which is connected to the cut-off switch, and the input of the feedback voltage of the voltage generation circuit. A control circuit controls operations of these switches.

With the above-mentioned configuration according to the present invention, it is possible to output a stable LED current without a voltage applied to a voltage-to-current converting circuit (base of LED drive transistor) being affected by fluctuations in external factors such as a temperature.
Further advantages, features, aspects and details are evident from the dependent claims, the description and the drawings.

### Brief Description of Drawings

So that the manner in which the above recited features of the present invention can be understood in detail, a more particular description of the invention, briefly summarized above, may be read by reference to comparative examples. The accompanying drawings relate to comparative examples related to the invention and are described in the following:
Fig. 1 is a diagram showing a configuration of a light projecting device drive circuit according to Comparative Example 1;
Fig. 2 is a waveform time chart at respective sections, which shows an operation of the light projecting device drive circuit according to Comparative Example 1;
Fig. 3 is a diagram showing the operation of the light projecting device drive circuit according to Comparative Example 1, in which (a) shows turn-on of an LED and (b) shows turn-off of the LED;
Fig. 4 is a diagram explaining a voltage drop when a cut-off switch of the light projecting device drive circuit according to Comparative Example 1 is in a connected state;
Fig. 5 is a diagram showing a configuration of a light projecting device drive circuit according to Comparative Example 2; and
Fig. 6 is a diagram showing a configuration of a conventional light projecting device drive circuit.

### Detailed Description of Embodiments

Hereinafter, embodiments of the present invention will be described in detail with reference to the drawings.

### Comparative Example 1.

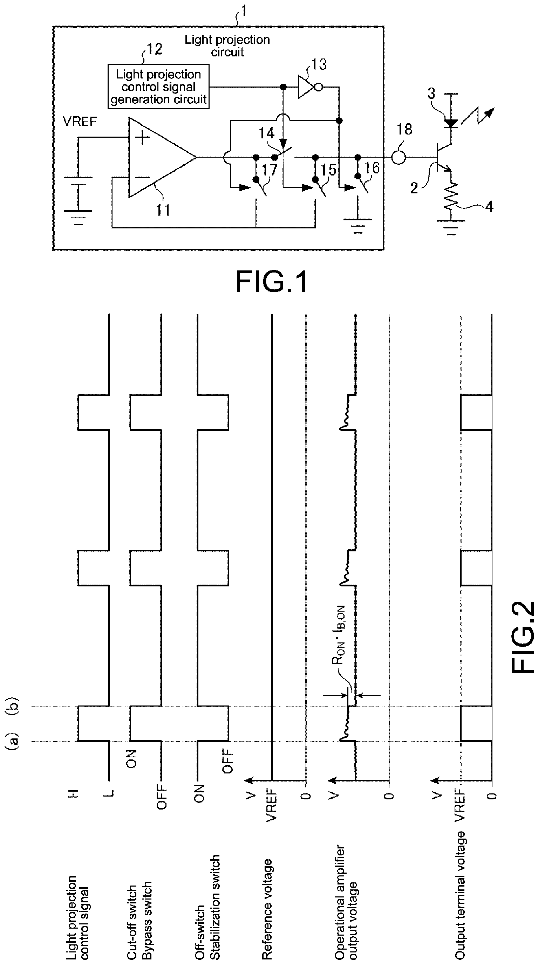

Fig. 1 is a diagram showing a configuration of a light projecting device drive circuit according to Comparative Example 1 of the present invention.

The light projecting device drive circuit outputs an LED current for driving a light projecting device (LED) 3. As shown in Fig. 1, the light projecting device drive circuit is constituted of a light projection circuit 1 that outputs a constant voltage and an LED drive transistor (voltage-to-current converting circuit) 2 that outputs an LED current depending on a voltage output from the light projection circuit 1. Note that, in Comparative Example 1, an NPN transistor is used as the LED drive transistor 2. Further, the LED 3 is connected to a collector of the LED drive transistor 2 and an LED current-limiting resistor 4 for limiting an LED-driving current is connected to an emitter of the LED drive transistor 2.

The light projection circuit 1 includes an operational amplifier (voltage generation circuit) 11, a light projection control signal generation circuit 12, a NOT circuit 13, a cut-off switch 14, a bypass switch 15, an off-switch 16, and a stabilization switch 17.

The operational amplifier 11 generates, based on a constant reference voltage (reference voltage) VREF and a feedback voltage, a voltage adjusted such that the feedback voltage approaches the reference voltage. An output of the operational amplifier 11 is connected to a base of the LED drive transistor 2 (output terminal 18) via the cut-off switch 14. Further, the reference voltage is input into a non-inverted input terminal of the operational amplifier 11. Further, a voltage of the base of the LED drive transistor 2, which is connected to the cut-off switch 14, is input into an inverted input terminal of the operational amplifier 11 via the bypass switch 15. Otherwise, a voltage of the output of the operational amplifier 11, which is connected to the cut-off switch 14, is input into the inverted input terminal via the stabilization switch 17.

The light projection control signal generation circuit 12 generates a light projection control signal for controlling an operation of each of the switches 14 to 17. The light projection control signal generated by the light projection control signal generation circuit 12 is output to the NOT circuit 13, the cut-off switch 14, and the bypass switch 15.

The NOT circuit 13 logically negates (inverts) an input light projection control signal. More particularly, the NOT circuit 13 outputs an H-level signal when an L-level signal is input as the light projection control signal. The NOT circuit 13 outputs an L-level signal when an H-level signal is input. The light projection control signal inverted by the NOT circuit 13 is output to the off-switch 16 and the stabilization switch 17.

Note that the light projection control signal generation circuit 12 and the NOT circuit 13 constitute "a control circuit configured to bring the cut-off switch and the bypass switch into a connected state when the light projecting device is turned on and to bring the off-switch and the stabilization switch into a connected state when the light projecting device is turned off" in the present invention.

The cut-off switch 14 switches connection/disconnection between the output of the operational amplifier 11 and the base of the LED drive transistor 2 according to an input light projection control signal. In order to turn off the LED 3, the cut-off switch 14 prevents an output voltage from the operational amplifier 11 from being applied to the base of the LED drive transistor 2.

The bypass switch 15 switches connection/disconnection between the base of the LED drive transistor 2, which is connected to the cut-off switch 14, and the inverted input terminal of the operational amplifier 11 according to an input light projection control signal. The bypass switch 15 feeds back a voltage of the base of the LED drive transistor 2, which is connected to the cut-off switch 14, to the operational amplifier 11 when the cut-off switch 14 is in a connected state.

The off-switch 16 switches connection/disconnection between the base of the LED drive transistor 2, which is connected to the cut-off switch 14, and a potential different from a potential at the output of the operational amplifier 11 according to a light projection control signal input via the NOT circuit 13. Note that, in Comparative Example 1, the off-switch 16 is configured to switch the connection/disconnection between the base of the LED drive transistor 2, which is connected to the cut-off switch 14, and a ground (GND). The off-switch 16 changes a voltage of the base of the LED drive transistor 2, which is connected to the cut-off switch 14, into a GND potential when the cut-off switch 14 is in a disconnected state.

The stabilization switch 17 switches connection/disconnection between the output of the operational amplifier 11, which is connected to the cut-off switch 14, and the inverted input terminal of the operational amplifier 11 according to a light projection control signal input via the NOT circuit 13. The stabilization switch 17 feeds back the voltage of the output of the operational amplifier 11, which is connected to the cut-off switch 14, to the operational amplifier 11 when the cut-off switch 14 is in the disconnected state.

Next, an operation of the light projecting device drive circuit configured in the above-mentioned manner will be described with reference to Figs. 1 to 4.

In the operation of the light projecting device drive circuit, in order to turn on the LED 3, as shown in Fig. 1 and (a) of Fig. 2, the light projection control signal generation circuit 12 generates an H-level signal as the light projection control signal and outputs the H-level signal to the NOT circuit 13, the cut-off switch 14, and the bypass switch 15. The NOT circuit 13 inverts the H-level light projection control signal and outputs an L-level signal to the off-switch 16 and the stabilization switch 17.

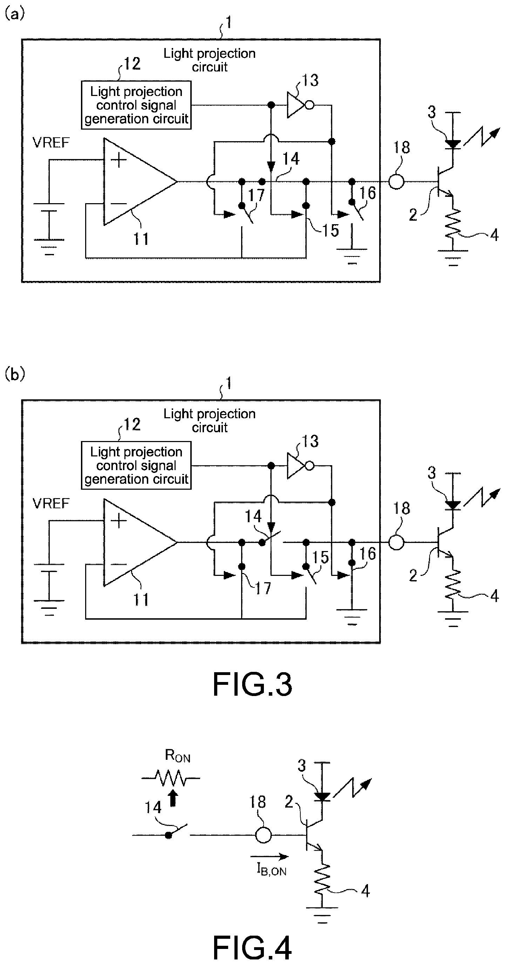

With this, as shown in (a) of Fig. 2 and (a) of Fig. 3, the cut-off switch 14 and the bypass switch 15 into which the H-level light projection control signal is input are in a connected state (ON) and the off-switch 16 and the stabilization switch 17 into which the L-level light projection control signal is input are in a disconnected state (OFF).

The cut-off switch 14 is in the connected state, and hence a voltage from the operational amplifier 11 is applied to the base of the LED drive transistor 2. At this time, the operational amplifier 11 generates an output voltage based on a reference voltage VREF, and hence it is possible to apply a stable voltage that is not affected by changes in an external environment such as a temperature to the base of the LED drive transistor 2. Thus, a base voltage of the LED drive transistor 2 is made constant, and hence a current value of the LED current can be made constant.

On the other hand, the cut-off switch 14 is in the connected state, and hence, as shown in Fig. 4, a voltage drop R_{ON}*I_{B,ON} is generated at both ends of the cut-off switch 14 due to a base current I_{B,ON} of the LED drive transistor 2 and an on-resistance R_{ON} of the cut-off switch 14. In view of this, by bringing the bypass switch 15 into the connected state when the cut-off switch 14 is in the connected state, the feedback voltage to the operational amplifier 11 is set to a value including an error due to the on-resistance R_{ON} of the cut-off switch 14. With this, it is possible to eliminate influence of the voltage drop due to the base current I_{B,ON} of the LED drive transistor 2 and the on-resistance R_{ON} of the cut-off switch 14, and to improve a voltage accuracy of the output voltage of the light projection circuit 1.

Next, in order to turn off the LED 3, as shown in Fig. 1 and (b) of Fig. 2, the light projection control signal generation circuit 12 generates an L-level signal as the light projection control signal and outputs the L-level signal to the NOT circuit 13, the cut-off switch 14, and the bypass switch 15. The NOT circuit 13 inverts the L-level light projection control signal and outputs an H-level signal to the off-switch 16 and the stabilization switch 17.

With this, as shown in (b) of Fig. 2 and (b) of Fig. 3, the cut-off switch 14 and the bypass switch 15 into which the L-level light projection control signal is input are in a disconnected state (OFF) and the off-switch 16 and the stabilization switch 17 into which the H-level light projection control signal is input are in a connected state (ON).

The cut-off switch 14 is in the disconnected state, and hence the voltage from the operational amplifier 11 is not applied to the base of the LED drive transistor 2 and the LED 3 can be turned off.

However, even when the cut-off switch 14 is brought into the disconnected state and the voltage application to the LED drive transistor 2 is stopped, a turn-off time is extended due to a parasitic capacitance generated at the base of the LED drive transistor 2 and the LED 3 is not quickly turned off. In view of this, by bringing the off-switch 16 into the connected state when the LED 3 is turned off, the voltage of the output terminal 18, which is connected to the cut-off switch 14, is set to the GND potential. With this, it is possible to forcibly turn off the LED drive transistor 2 and to shorten a transition time when the LED 3 is turned off.

Further, if the output of the operational amplifier 11 is largely fluctuated from the reference voltage VREF when the LED 3 is turned off, a transition time is extended when the LED 3 is turned on later. In view of this, by bringing the stabilization switch 17 into the connected state when the LED 3 is turned off, the voltage of the output of the operational amplifier 11, which is connected to the cut-off switch 14, is fed back to the operational amplifier 11. With this, it is possible to keep the voltage of the output of the operational amplifier 11, which is connected to the cut-off switch 14, near the reference voltage also when the LED 3 is turned off. Thus, when a voltage is applied to the base of the LED drive transistor 2 for turning on the LED 3, the voltage changes only by an amount corresponding to a potential difference corresponding to the error due to the on-resistance of the cut-off switch 14.

As described above, according to Comparative Example 1, provided are the operational amplifier 11 that generates, based on the constant reference voltage and the feedback voltage, the voltage adjusted such that the feedback voltage approaches the reference voltage, the LED drive transistor 2 that generates the LED current depending on the input voltage, the cut-off switch 14 that switches the connection/disconnection between the output of the operational amplifier 11 and the base of the LED drive transistor 2, the bypass switch 15 that switches the connection/disconnection between the base of the LED drive transistor 2, which is connected to the cut-off switch 14, and the inverted input terminal of the operational amplifier 11, the off-switch 16 that switches the connection/disconnection between the base of the LED drive transistor 2, which is connected to the cut-off switch 14, and the GND, the stabilization switch 17 that switches the connection/disconnection between the output of the operational amplifier 11, which is connected to the cut-off switch 14, and the inverted input terminal of the operational amplifier 11, and the light projection control signal generation circuit 12 and the NOT circuit 13 that bring the cut-off switch 14 and the bypass switch 15 into the connected state when the LED 3 is turned on and that bring the off-switch 16 and the stabilization switch 17 into the connected state when the LED 3 is turned off. Thus, it is possible to output a stable LED current without the voltage applied to the base of the LED drive transistor 2 being affected by fluctuations in external factors such as a temperature.

### Comparative Example 2.

In Comparative Example 1, the NPN transistor is used as the LED drive transistor 2. In Comparative Example 2, a PNP transistor is used as an LED drive transistor 2b and the reference of the circuit configuration is changed from the GND to a power-supply Vcc.

Fig. 5 is a diagram showing a configuration of a light projecting device drive circuit according to Comparative Example 2 of the present invention. A light projection circuit 1 according to Comparative Example 2 shown in Fig. 5 includes an off-switch 16b instead of the off-switch 16 of the light projection circuit 1 according to Comparative Example 1 shown in Fig. 1.

The off-switch 16b switches, according to a light projection control signal input via a NOT circuit 13, connection/disconnection between a base of an LED drive transistor 2b, which is connected the cut-off switch 14, and a potential different from a potential at an output of an operational amplifier 11. Note that, in Comparative Example 2, the off-switch 16b is configured to switch connection/disconnection between the base of the LED drive transistor 2b, which is connected to the cut-off switch 14, and the power-supply Vcc. The off-switch 16b sets the voltage of the base of the LED drive transistor 2b, which is connected to the cut-off switch 14, to a Vcc potential when the cut-off switch 14 is in a disconnected state.

Further, a reference voltage input into a non-inverted input terminal of the operational amplifier 11 is also generated based on Vcc.

Other configurations and operations are the same as the configurations and operations in Comparative Example 1, and hence descriptions thereof will be omitted.

As described above, according to Comparative Example 2, also when the NPN transistor is replaced by the PNP transistor, the same effects as those of Comparative Example 1 can be provided.

Note that, in Comparative Examples 1 and 2, a bipolar transistor is used as the LED drive transistor 2 or 2b. However, it is not limited thereto and a field effect transistor such as a metal-oxide semiconductor (MOS) transistor may be used as the LED drive transistor 2 or 2b.

The configurations of Comparative Examples 1 and 2 are different from each other only in a connection form of the off-switches 16 and 16b and a method of applying the reference voltage. Therefore, it is also possible to provide and selectively use both NPN and PNP driving modes in an embodiment of the invention.

In this case, one of an NPN transistor and a PNP transistor are provided as the LED drive transistor 2 or 2b. Further, a first switch 16 that switches connection/disconnection between the base of the LED drive transistor 2, which is connected to the cut-off switch 14, and the GND and a second switch 16b that switches connection/disconnection between the base of the LED drive transistor 2 or 2b, which is connected to the cut-off switch 14, and the power-supply Vcc are provided as the off-switch 16, 16b. Further, as the reference voltage, a voltage based on the GND and a voltage based on the power-supply Vcc are configured to be switchable. In addition, a selector is adapted to select one of the NPN transistor and the PNP transistor being used as LED drive transistor. In other words, only one of these transistors is active at the same time. A switch controller that changes the reference voltage to be used and turns on/off the off-switch 16 according to a selection by the selector is provided. For example, the switch controller is adapted to activate or use, according to the selected transistor selected by the selector, only one of the first and second switches for connecting the base of the LED drive transistor 2, 2b selectively to the reference voltage to be used, for example to shorten the transition time when turning off the LED, whereas the other one of the first and second switches remains open.
In an embodiment, which may be combined with other embodiments, the reference voltage can be easily realized by a resistance voltage divider between the Vcc and the GND changing a voltage dividing point according to the selection of the NPN transistor/the PNP transistor.

It should be noted that an arbitrary combination of the above-mentioned embodiments can be made, various changes can be made in an arbitrary component according to either one of the above-mentioned embodiments, and an arbitrary component according to either one of the above-mentioned embodiments can be omitted within the scope of the invention.

## Claims

1. A light projecting device drive circuit (1) configured to output a current for driving a light projecting device (3), the light projecting device drive circuit comprising:
a voltage generation circuit (11) configured to generate, based on a constant reference voltage (VREF) and a feedback voltage, a voltage adjusted such that the feedback voltage approaches the reference voltage;
a voltage-to-current converting circuit (2, 2b) configured to generate the current depending on an input voltage;
a cut-off switch (14) configured to switch connection/disconnection between an output of the voltage generation circuit (11) and an input of the voltage-to-current converting circuit (2, 2b);
a bypass switch (15) configured to switch connection/disconnection between the input of the voltage-to-current converting circuit (2, 2b), which is connected to the cut-off switch, and an input of the feedback voltage of the voltage generation circuit (11);
an off-switch (16, 16b) configured to switch connection/disconnection between the input of the voltage-to-current converting circuit (2, 2b), which is connected to the cut-off switch, and a potential different from a potential at the output of the voltage generation circuit (11);
a stabilization switch (17) configured to switch connection/disconnection between the output of the voltage generation circuit (11), which is connected to the cut-off switch (14), and the input of the feedback voltage of the voltage generation circuit (11); and
a control circuit (12, 13) configured to bring the cut-off switch (14) and the bypass switch (15) into a connected state when the light projecting device is to be turned on and to bring the off-switch (16, 16b) and the stabilization switch (17) into a connected state when the light projecting device is to be turned off, wherein
the voltage-to-current converting circuit (2, 2b) includes one of an NPN transistor and a PNP transistor,
the reference voltage input into the voltage generation circuit (11) is switchable to a voltage generated based on a ground (GND) and to a voltage generated based on a predetermined power-supply (Vcc),
the off-switch (16, 16b) includes
a first switch (16) configured to switch connection/disconnection between the input of the voltage-to-current converting circuit (2, 2b), which is connected to the cut-off switch (14), and the ground (GND), and
a second switch (16b) configured to switch connection/disconnection between the input of the voltage-to-current converting circuit (2, 2b), which is connected to the cut-off switch (14), and the power-supply (Vcc), the light projecting device drive circuit further comprising:
a selector adapted to select one of an NPN transistor driving mode or a PNP transistor driving mode; and
a switch controller configured to change the reference voltage to be used and to activate one of the first and second switches (16, 16b) according to the selected driving mode by the selector.

2. The light projecting device drive circuit according to claim 1, wherein
the voltage-to-current converting (2) circuit is an NPN transistor,
the reference voltage input into the voltage generation circuit is a voltage generated based on a ground (GND), and
the off-switch (16) is configured to switch connection/disconnection between the input of the voltage-to-current converting circuit, which is connected to the cut-off switch, and the ground (GND).

3. The light projecting device drive circuit according to claim 1, wherein
the voltage-to-current converting circuit (2b) is a PNP transistor,
the reference voltage input into the voltage generation circuit is a voltage generated based on a predetermined power-supply (Vcc), and
the off-switch (16b) is configured to switch connection/disconnection between the input of the voltage-to-current converting circuit, which is connected to the cut-off switch, and the power-supply.

4. A light projecting device drive circuit (1) configured to output a current for driving a light projecting device (3), the light projecting device drive circuit comprising:
a voltage generation circuit (11) configured to generate, based on a constant reference voltage (VREF) and a feedback voltage, a voltage adjusted such that the feedback voltage approaches the reference voltage;
a voltage-to-current converting circuit (2, 2b) configured to generate the current depending on an input voltage;
a cut-off switch (14) configured to switch connection/disconnection between an output of the voltage generation circuit (11) and an input of the voltage-to-current converting circuit (2, 2b);
a bypass switch (15) configured to switch connection/disconnection between the input of the voltage-to-current converting circuit (2, 2b), which is connected to the cut-off switch, and an input of the feedback voltage of the voltage generation circuit (11);
an off-switch (16, 16b) configured to switch connection/disconnection between the input of the voltage-to-current converting circuit (2, 2b), which is connected to the cut-off switch, and a potential different from a potential at the output of the voltage generation circuit (11);
a stabilization switch (17) configured to switch connection/disconnection between the output of the voltage generation circuit (11), which is connected to the cut-off switch (14), and the input of the feedback voltage of the voltage generation circuit (11); and
a control circuit (12, 13) configured to bring the cut-off switch (14) and the bypass switch (15) into a connected state when the light projecting device is to be turned on and to bring the off-switch (16, 16b) and the stabilization switch (17) into a connected state when the light projecting device is to be turned off, wherein
the voltage-to-current converting circuit (2, 2b) includes one of a n-type MOSFET and a p-type MOSFET,
the reference voltage input into the voltage generation circuit (11) is switchable to a voltage generated based on a ground (GND) and to a voltage generated based on a predetermined power-supply (Vcc),
the off-switch (16, 16b) includes
a first switch (16) configured to switch connection/disconnection between the input of the voltage-to-current converting circuit (2, 2b), which is connected to the cut-off switch (14), and the ground (GND), and
a second switch (16b) configured to switch connection/disconnection between the input of the voltage-to-current converting circuit (2, 2b), which is connected to the cut-off switch (14), and the power-supply (Vcc), the light projecting device drive circuit further comprising:
a selector adapted to select one of an n-type MOSFET driving mode or a p-type MOSFET driving mode; and
a switch controller configured to change the reference voltage to be used and to activate one of the first and second switches (16, 16b) according to the selected driving mode by the selector.

5. The light projecting device drive circuit according to claim 4, wherein
the voltage-to-current converting (2) circuit is a n-type MOSFET,
the reference voltage input into the voltage generation circuit is a voltage generated based on a ground (GND), and
the off-switch (16) is configured to switch connection/disconnection between the input of the voltage-to-current converting circuit, which is connected to the cut-off switch, and the ground (GND).

6. The light projecting device drive circuit according to claim 4, wherein
the voltage-to-current converting circuit (2b) is a p-type MOSFET,
the reference voltage input into the voltage generation circuit is a voltage generated based on a predetermined power-supply (Vcc), and
the off-switch (16b) is configured to switch connection/disconnection between the input of the voltage-to-current converting circuit, which is connected to the cut-off switch, and the power-supply.

7. A photoelectric sensor, comprising:
a light projecting device drive circuit (1) according to any one of claims 1 to 6; and
a light projecting device (3) configured to emit light depending on the current output from the light projecting device drive circuit.

## Patentansprüche

1. Lichtprojektionsvorrichtung-Treiberschaltung (1), die dafür konfiguriert ist, einen Strom zum Treiben einer Lichtprojektionsvorrichtung (3) auszugeben, wobei die Lichtprojektionsvorrichtung-Treiberschaltung Folgendes umfasst:
eine Spannungserzeugungsschaltung (11), die dafür konfiguriert ist, basierend auf einer konstanten Referenzspannung (VREF) und einer Rückkopplungsspannung eine Spannung zu erzeugen, die derart justiert ist, dass die Rückkopplungsspannung sich der Referenzspannung annähert,
eine Spannungs-Strom-Wandlerschaltung (2, 2b), die dazu ausgestaltet ist, den Strom in Abhängigkeit von einer Eingangsspannung zu erzeugen,
einen Trennschalter (14), der dazu ausgestaltet ist, eine Verbindung/Trennung zwischen einem Ausgang der Spannungserzeugungsschaltung (11) und einem Eingang der Spannungs-Strom-Wandlerschaltung (2, 2b) zu schalten,
einen Überbrückungsschalter (15), der dazu ausgestaltet ist, eine Verbindung/Trennung zwischen dem Eingang der Spannungs-Strom-Wandlerschaltung (2, 2b), die mit dem Trennschalter verbunden ist, und einem Eingang der Rückkopplungsspannung der Spannungserzeugungsschaltung (11) zu schalten,
einen Ausschalter (16, 16b), der dazu ausgestaltet ist, eine Verbindung/Trennung zwischen dem Eingang der Spannungs-Strom-Wandlerschaltung (2, 2b), die mit dem Trennschalter verbunden ist, und einem Potential zu schalten, das sich von einem Potential an dem Ausgang der Spannungserzeugungsschaltung (11) unterscheidet,
einen Stabilisierungsschalter (17), der dazu ausgestaltet ist, eine Verbindung/Trennung zwischen dem Ausgang der Spannungserzeugungsschaltung (11), die mit dem Trennschalter (14) verbunden ist, und dem Eingang der Rückkopplungsspannung der Spannungserzeugungsschaltung (11) zu schalten, und
eine Steuerschaltung (12, 13), die dazu ausgestaltet ist, den Trennschalter (14) und den Überbrückungsschalter (15) in einen verbundenen Zustand zu bringen, wenn die Lichtprojektionsvorrichtung angeschaltet werden soll, und den Ausschalter (16, 16b) und den Stabilisierungsschalter (17) in einen verbundenen Zustand zu bringen, wenn die Lichtprojektionsvorrichtung ausgeschaltet werden soll, wobei
die Spannungs-Strom-Wandlerschaltung (2, 2b) einen von einem NPN-Transistor und einem PNP-Transistor beinhaltet,
die in die Spannungserzeugungsschaltung (11) eingegebene Referenzspannung auf eine Spannung schaltbar ist, die basierend auf einer Masse (GND) erzeugt wird, und auf eine Spannung, die basierend auf einer vorbestimmten Energieversorgung (Vcc) erzeugt wird,
der Ausschalter (16, 16b) Folgendes beinhaltet:
einen ersten Schalter (16), der dazu ausgestaltet ist, eine Verbindung/Trennung zwischen dem Eingang der Spannungs-Strom-Wandlerschaltung (2, 2b), die mit dem Trennschalter (14) verbunden ist, und der Masse (GND) zu schalten, und
einen zweiten Schalter (16b), der dazu ausgestaltet ist, eine Verbindung/Trennung zwischen dem Eingang der Spannungs-Strom-Wandlerschaltung (2, 2b), die mit dem Trennschalter (14) verbunden ist, und der Energieversorgung (Vcc) zu schalten, wobei die Lichtprojektionsvorrichtung-Treiberschaltung ferner Folgendes umfasst:
einen Selektor, der dazu eingerichtet ist, einen von einem NPN-Transistor-Treibermodus oder einem PNP-Transistor-Treibermodus auszuwählen, und
eine Schaltersteuerung, die dafür konfiguriert ist, die zu verwendende Referenzspannung zu verändern und einen des ersten und des zweiten Schalters (16, 16b) gemäß dem von dem Selektor ausgewählten Treibermodus zu aktivieren.

2. Lichtprojektionsvorrichtung-Treiberschaltung nach Anspruch 1, wobei
die Spannungs-Strom-Wandlerschaltung (2) ein NPN-Transistor ist,
die in die Spannungserzeugungsschaltung eingegebene Referenzspannung eine Spannung ist, die basierend auf einer Masse (GND) erzeugt wird, und
der Ausschalter (16) dafür konfiguriert ist, eine Verbindung/Trennung zwischen dem Eingang der Spannungs-Strom-Wandlerschaltung, die mit dem Trennschalter verbunden ist, und der Masse (GND) zu schalten.

3. Lichtprojektionsvorrichtung-Treiberschaltung nach Anspruch 1, wobei
die Spannungs-Strom-Wandlerschaltung (2b) ein PNP-Transistor ist,
die in die Spannungserzeugungsschaltung eingegebene Referenzspannung eine Spannung ist, die basierend auf einer vorbestimmten Energieversorgung (Vcc) erzeugt wird, und
der Ausschalter (16b) dafür konfiguriert ist, eine Verbindung/Trennung zwischen dem Eingang der Spannungs-Strom-Wandlerschaltung, die mit dem Trennschalter verbunden ist, und der Energieversorgung zu schalten.

4. Lichtprojektionsvorrichtung-Treiberschaltung (1), die dazu ausgestaltet ist, einen Strom zum Treiben einer Lichtprojektionsvorrichtung (3) auszugeben, wobei die Lichtprojektionsvorrichtung-Treiberschaltung Folgendes umfasst:
eine Spannungserzeugungsschaltung (11), die dazu ausgestaltet ist, basierend auf einer konstanten Referenzspannung (VREF) und einer Rückkopplungsspannung eine Spannung zu erzeugen, die derart justiert ist, dass die Rückkopplungsspannung sich der Referenzspannung annähert,
eine Spannungs-Strom-Wandlerschaltung (2, 2b), die dazu ausgestaltet ist, den Strom in Abhängigkeit von einer Eingangsspannung zu erzeugen,
einen Trennschalter (14), der dazu ausgestaltet ist, eine Verbindung/Trennung zwischen einem Ausgang der Spannungserzeugungsschaltung (11) und einem Eingang der Spannungs-Strom-Wandlerschaltung (2, 2b) zu schalten,
einen Überbrückungsschalter (15), der dazu ausgestaltet ist, eine Verbindung/Trennung zwischen dem Eingang der Spannungs-Strom-Wandlerschaltung (2, 2b), die mit dem Trennschalter verbunden ist, und einem Eingang der Rückkopplungsspannung der Spannungserzeugungsschaltung (11) zu schalten,
einen Ausschalter (16, 16b), der dazu ausgestaltet ist, eine Verbindung/Trennung zwischen dem Eingang der Spannungs-Strom-Wandlerschaltung (2, 2b), die mit dem Trennschalter verbunden ist, und einem Potential zu schalten, das sich von einem Potential an dem Ausgang der Spannungserzeugungsschaltung (11) unterscheidet,
einen Stabilisierungsschalter (17), der dazu ausgestaltet ist, eine Verbindung/Trennung zwischen dem Ausgang der Spannungserzeugungsschaltung (11), die mit dem Trennschalter (14) verbunden ist, und dem Eingang der Rückkopplungsspannung der Spannungserzeugungsschaltung (11) zu schalten, und
eine Steuerschaltung (12, 13), die dazu ausgestaltet ist, den Trennschalter (14) und den Überbrückungsschalter (15) in einen verbundenen Zustand zu bringen, wenn die Lichtprojektionsvorrichtung angeschaltet werden soll, und den Ausschalter (16, 16b) und den Stabilisierungsschalter (17) in einen verbundenen Zustand zu bringen, wenn die Lichtprojektionsvorrichtung ausgeschaltet werden soll, wobei
die Spannungs-Strom-Wandlerschaltung (2, 2b) einen von einem n-Kanal-MOSFET und einem p-Kanal-MOSFET beinhaltet,
die in die Spannungserzeugungsschaltung (11) eingegebene Referenzspannung auf eine Spannung schaltbar ist, die basierend auf einer Masse (GND) erzeugt wird, und auf eine Spannung, die basierend auf einer vorbestimmten Energieversorgung (Vcc) erzeugt wird,
der Ausschalter (16, 16b) Folgendes beinhaltet:
einen ersten Schalter (16), der dazu ausgestaltet ist, eine Verbindung/Trennung zwischen dem Eingang der Spannungs-Strom-Wandlerschaltung (2, 2b), die mit dem Trennschalter (14) verbunden ist, und der Masse (GND) zu schalten, und
einen zweiten Schalter (16b), der dazu ausgestaltet ist, eine Verbindung/Trennung zwischen dem Eingang der Spannungs-Strom-Wandlerschaltung (2, 2b), die mit dem Trennschalter (14) verbunden ist, und der Energieversorgung (Vcc) zu schalten, wobei die Lichtprojektionsvorrichtung-Treiberschaltung ferner Folgendes umfasst.
einen Selektor, der dazu eingerichtet ist, einen von einem n-Kanal-MOSFET-Treibermodus oder einem p-Kanal-MOSFET-Transistor-Treibermodus auszuwählen, und
eine Schaltersteuerung, die dazu ausgestaltet ist, die zu verwendende Referenzspannung zu verändern und einen des ersten und des zweiten Schalters (16, 16b) gemäß dem von dem Selektor ausgewählten Treibermodus zu aktivieren.

5. Lichtprojektionsvorrichtung-Treiberschaltung nach Anspruch 4, wobei
die Spannungs-Strom-Wandlerschaltung (2) ein n-Kanal-MOSFET ist,
die in die Spannungserzeugungsschaltung eingegebene Referenzspannung eine Spannung ist, die basierend auf einer Masse (GND) erzeugt wird, und
der Ausschalter (16) dazu ausgestaltet ist, eine Verbindung/Trennung zwischen dem Eingang der Spannungs-Strom-Wandlerschaltung, die mit dem Trennschalter verbunden ist, und der Masse (GND) zu schalten.

6. Lichtprojektionsvorrichtung-Treiberschaltung nach Anspruch 4, wobei
die Spannungs-Strom-Wandlerschaltung (2b) ein p-Kanal-MOSFET ist,
die in die Spannungserzeugungsschaltung eingegebene Referenzspannung eine Spannung ist, die basierend auf einer vorbestimmten Energieversorgung (Vcc) erzeugt wird, und
der Ausschalter (16b) dazu ausgestaltet ist, eine Verbindung/Trennung zwischen dem Eingang der Spannungs-Strom-Wandlerschaltung, die mit dem Trennschalter verbunden ist, und der vorbestimmten Energieversorgung (Vcc) zu schalten.

7. Photoelektrischer Sensor, umfassend:
eine Lichtprojektionsvorrichtung-Treiberschaltung (1) nach einem der Ansprüche 1 bis 6 und
eine Lichtprojektionsvorrichtung (3), die dazu ausgestaltet ist, Licht in Abhängigkeit von dem Strom auszugeben, der von der Lichtprojektionsvorrichtung-Treiberschaltung ausgegeben wird.

## Revendications

1. Circuit de commande de dispositif de projection de lumière (1) configuré pour délivrer un courant pour commander un dispositif de projection de lumière (3), le circuit de commande de dispositif de projection de lumière comprenant :
un circuit de génération de tension (11) configuré pour générer, sur la base d'une tension de référence constante (VREF) et d'une tension de rétroaction, une tension ajustée de sorte que la tension de rétroaction s'approche de la tension de référence ;
un circuit de conversion tension-courant (2, 2b) configuré pour générer le courant en fonction d'une tension d'entrée ;
un commutateur de coupure (14) configuré pour commuter la connexion/déconnexion entre une sortie du circuit de génération de tension (11) et une entrée du circuit de conversion tension-courant (2, 2b) ;
un commutateur de dérivation (15) configuré pour commuter la connexion/déconnexion entre l'entrée du circuit de conversion tension-courant (2, 2b), qui est connectée au commutateur de coupure, et une entrée de la tension de rétroaction du circuit de génération de tension (11) ;
un commutateur d'extinction (16, 16b) configuré pour commuter la connexion/déconnexion entre l'entrée du circuit de conversion tension-courant (2, 2b), qui est connectée au commutateur de coupure, et un potentiel différent d'un potentiel à la sortie du circuit de génération de tension (11) ;
un commutateur de stabilisation (17) configuré pour commuter la connexion/déconnexion entre la sortie du circuit de génération de tension (11), qui est connectée au commutateur de coupure (14), et l'entrée de la tension de rétroaction du circuit de génération de tension (11) ; et
un circuit de commande (12, 13) configuré pour mettre le commutateur de coupure (14) et le commutateur de dérivation (15) dans un état connecté lorsque le dispositif de projection de lumière doit être allumé et pour mettre le commutateur d'extinction (16, 16b) et le commutateur de stabilisation (17) dans un état connecté lorsque le dispositif de projection de lumière doit être éteint, dans lequel
le circuit de conversion tension-courant (2, 2b) comprend l'un parmi un transistor NPN et un transistor PNP,
la tension de référence appliquée au circuit de génération de tension (11) peut être commutée vers une tension générée sur la base d'une masse (GND) et vers une tension générée sur la base d'une alimentation (Vcc) prédéterminée,
le commutateur d'extinction (16, 16b) comprend :
un premier commutateur (16) configuré pour commuter la connexion/déconnexion entre l'entrée du circuit de conversion tension-courant (2, 2b), qui est connectée au commutateur de coupure (14), et la masse (GND), et
un deuxième commutateur (16b) configuré pour commuter la connexion/déconnexion entre l'entrée du circuit de conversion tension-courant (2, 2b), qui est connectée au commutateur de coupure (14), et l'alimentation (Vcc), le circuit de commande de dispositif de projection de lumière comprenant en outre :
un sélecteur conçu pour sélectionner l'un parmi un mode de commande de transistor NPN et un mode de commande de transistor PNP ; et
un contrôleur de commutateur configuré pour changer la tension de référence à utiliser et pour activer l'un des premier et deuxième commutateurs (16, 16b) conformément au mode de commande sélectionné par le sélecteur.

2. Circuit de commande de dispositif de projection de lumière selon la revendication 1, dans lequel
le circuit de conversion tension-courant (2) est un transistor NPN,
la tension de référence appliquée au circuit de génération de tension est une tension générée sur la base d'une masse (GND), et
le commutateur d'extinction (16) est configuré pour commuter la connexion/déconnexion entre l'entrée du circuit de conversion tension-courant, qui est connectée au commutateur de coupure, et la masse (GND).

3. Circuit de commande de dispositif de projection de lumière selon la revendication 1, dans lequel
le circuit de conversion tension-courant (2b) est un transistor PNP,
la tension de référence appliquée au circuit de génération de tension est une tension générée sur la base d'une alimentation (Vcc) prédéterminée, et
le commutateur d'extinction (16b) est configuré pour commuter la connexion/déconnexion entre l'entrée du circuit de conversion tension-courant, qui est connectée au commutateur de coupure, et l'alimentation.

4. Circuit de commande de dispositif de projection de lumière (1) configuré pour délivrer un courant pour commander un dispositif de projection de lumière (3), le circuit de commande de dispositif de projection de lumière comprenant :
un circuit de génération de tension (11) configuré pour générer, sur la base d'une tension de référence constante (VREF) et d'une tension de rétroaction, une tension ajustée de sorte que la tension de rétroaction s'approche de la tension de référence ;
un circuit de conversion tension-courant (2, 2b) configuré pour générer le courant en fonction d'une tension d'entrée ;
un commutateur de coupure (14) configuré pour commuter la connexion/déconnexion entre une sortie du circuit de génération de tension (11) et une entrée du circuit de conversion tension-courant (2, 2b) ;
un commutateur de dérivation (15) configuré pour commuter la connexion/déconnexion entre l'entrée du circuit de conversion tension-courant (2, 2b), qui est connectée au commutateur de coupure, et une entrée de la tension de rétroaction du circuit de génération de tension (11) ;
un commutateur d'extinction (16, 16b) configuré pour commuter la connexion/déconnexion entre l'entrée du circuit de conversion tension-courant (2, 2b), qui est connectée au commutateur de coupure, et un potentiel différent d'un potentiel à la sortie du circuit de génération de tension (11) ;
un commutateur de stabilisation (17) configuré pour commuter la connexion/déconnexion entre la sortie du circuit de génération de tension (11), qui est connectée au commutateur de coupure (14), et l'entrée de la tension de rétroaction du circuit de génération de tension (11) ; et
un circuit de commande (12, 13) configuré pour mettre le commutateur de coupure (14) et le commutateur de dérivation (15) dans un état connecté lorsque le dispositif de projection de lumière doit être allumé et pour mettre le commutateur d'extinction (16, 16b) et le commutateur de stabilisation (17) dans un état connecté lorsque le dispositif de projection de lumière doit être arrêté, dans lequel
le circuit de conversion tension-courant (2, 2b) comprend l'un parmi un MOSFET de type n et un MOSFET de type p,
la tension de référence appliquée au circuit de génération de tension (11) peut être commutée vers une tension générée sur la base d'une masse (GND) et vers une tension générée sur la base d'une alimentation (Vcc) prédéterminée,
le commutateur d'extinction (16, 16b) comprend :
un premier commutateur (16) configuré pour commuter la connexion/déconnexion entre l'entrée du circuit de conversion tension-courant (2, 2b), qui est connectée au commutateur de coupure (14), et la masse (GND), et
un deuxième commutateur (16b) configuré pour commuter la connexion/déconnexion entre l'entrée du circuit de conversion tension-courant (2, 2b), qui est connectée au commutateur de coupure (14), et l'alimentation (Vcc), le circuit de commande de dispositif de projection de lumière comprenant en outre :
un sélecteur conçu pour sélectionner l'un parmi un mode de commande de MOSFET de type n et un mode de commande de MOSFET de type p ; et
un contrôleur de commutateur configuré pour changer la tension de référence à utiliser et pour activer l'un des premier et deuxième commutateurs (16, 16b) conformément au mode de commande sélectionné par le sélecteur.

5. Circuit de commande de dispositif de projection de lumière selon la revendication 4, dans lequel
le circuit de conversion tension-courant (2) est un MOSFET de type n,
la tension de référence appliquée au circuit de génération de tension est une tension générée sur la base d'une masse (GND), et
le commutateur d'extinction (16) est configuré pour commuter la connexion/déconnexion entre l'entrée du circuit de conversion tension-courant, qui est connectée au commutateur de coupure, et la masse (GND).

6. Circuit de commande de dispositif de projection de lumière selon la revendication 4, dans lequel
le circuit de conversion tension-courant (2b) est un MOSFET de type p,
la tension de référence appliquée au circuit de génération de tension est une tension générée sur la base d'une alimentation (Vcc) prédéterminée, et
le commutateur d'extinction (16b) est configuré pour commuter la connexion/déconnexion entre l'entrée du circuit de conversion tension-courant, qui est connectée au commutateur de coupure, et l'alimentation.

7. Capteur photoélectrique, comprenant :
un circuit de commande de dispositif de projection de lumière (1) selon l'une quelconque des revendications 1 à 6 ; et
un dispositif de projection de lumière (3) configuré pour émettre de la lumière en fonction du courant délivré par le circuit de commande de dispositif de projection de lumière.
